# EUROPÄISCHE PATENTANMELDUNG

(11) **EP 2 475 014 A2**
(43) Veröffentlichungstag der Anmeldung: **11.07.2012**
(21) Anmeldenummer: 12150850.1
(22) Anmeldetag: 11.01.2012
(51) Int. Cl.: H01L 31/05, H01L 27/142

(54) **Photovoltaikmodul mit einlaminierter Bypassdiode**

(30) Priorität: 11.01.2011 DE 202011001341 U
(71) Anmelder: Conergy AG, 20537 Hamburg (DE)
(72) Erfinder: Zabel, Andreas, 20537 Hamburg (DE); Bartholomäus, Lars, 20537 Hamburg (DE)
(74) Vertreter: Birken, Lars

(57) **Zusammenfassung**

Die Erfindung betrifft ein Photovoltaikmodul, umfassend zumindest eine erste und eine zweite Solarzelleneinheit, die miteinander elektrisch in einer Reihenschaltung verbunden sind zur Erzeugung einer addierten Zellenspannung und eine Überbrückungsdiode, die elektrisch parallel mit der ersten Solarzelleneinheit verbunden ist zur Überbrückung der Solarzelleneinheit im Falle einer vollständigen oder teilweisen Abschattung der ersten Solarzelleneinheit. Erfindungsgemäß ist die Diode (10) mit einem ersten Leiter verbunden (20), der mit einer ersten Elektrode der parallel zur Diode geschalteten ersten Solarzelleneinheit elektrisch verbunden ist, und ist die Diode mit einem zweiten Leiter (30) verbunden, der mit einer zweiten, der ersten Elektrode entgegengesetzt gepolten Elektrode der parallel zur Diode geschalteten ersten Solarzelleneinheit elektrisch verbunden ist und der zweite Leiter weist benachbart zu dessen Verbindungsstelle mit der Diode ein Zugentlastungselement auf (32).

## Beschreibung

Die Erfindung betrifft ein Photovoltaikmodul, umfassend zumindest eine erste und eine zweite Solarzelleneinheit, die miteinander elektrisch in einer Reihenschaltung verbunden sind zur Erzeugung einer addierten Zellenspannung und eine Überbrückungsdiode, die elektrisch parallel mit der ersten Solarzelleneinheit verbunden ist zur Überbrückung der Solarzelleneinheit im Falle einer vollständigen oder teilweisen Abschattung der ersten Solarzelleneinheit.

Solarmodule dieser Bauweise sind bekannt und werden dazu eingesetzt, um elektrische Energie aus solarer Einstrahlung zu gewinnen. Solarmodule werden zu diesem Zweck in solcher Weise aufgebaut, dass sie typischerweise mehrere nebeneinander angeordnete Solarzellen umfassen, die durch einen in bestimmter Weise ausgeführte elektrische Kopplung in Reihe verbunden und diese wiederum parallel mit anderen seriell gekoppelten Solarzellen des Moduls so verschaltet sind, dass ein elektrischer Strom mit einer bestimmten Stromstärke und - spannung in dem Solarmodul erzeugt wird.

Die dabei erzielte Stromstärke ist u.a. von der Strahlungsintensität abhängig, welche auf die Solarzellen auftrifft. Solarzellen üblicher Bauart, beispielsweise also mono- oder polykristalline Siliziumsolarzellen oder UMG-Siliziumsolarzellen weisen dabei die Eigenschaft auf, dass sie bei geringer einfallender Strahlungsintensität einerseits keine nennenswerte Ausgangsstromstärke und -spannung erzeugten, darüber hinaus aber auch einen erheblichen Innenwiderstand aufbauen. Es besteht daher die grundsätzliche Problematik, dass in einer Reihenschaltung mehrerer solcher Solarzellen, dann, wenn eine der in Reihe geschalteten Solarzellen durch beispielsweise eine Abschattung mit wenig Strahlung beaufschlagt wird, der gesamte Widerstand in der Reihenschaltung steigt und hierdurch auch die noch mit ausreichender Strahlung beaufschlagten Solarzellen in der Reihenschaltung nicht in wirksamer Weise elektrische Energie über die Reihenschaltung abführen können, sondern stattdessen zu einer Aufheizung der abgeschalteten Solarzelle beitragen.

Zur Lösung dieser Problematik ist es bekannt, parallel geschaltete Bypass-Dioden vorzusehen, die durch Überbrückung eines Solarzellenstrings, in dem durch Abschattung einzelner oder mehrerer Solarzellen ein hoher Innenwiderstand entstanden ist, den widerstandsarmen Stromfluss um einen solchen String zu ermöglichen. Es ist bekannt, diese Dioden im Anschlusskasten eines Solarmoduls bereitzustellen, um hierdurch den Dioden eine ausreichende Kühlung zu ermöglichen, da sich die Dioden im Bypass-Betrieb aufgrund der hohen Stromstärken, die durch sie hindurchfließen, erheblich erwärmen können.

Nachteilig für diese Art der Anordnung der Bypass-Dioden ist allerdings, dass hierdurch ein erheblicher Verschaltungs- und Leitungsaufwand auf und in dem Solarmodul betrieben werden muss, um eine entsprechende Stromführung zu und von diesen Dioden in einer entsprechenden Parallelschaltung zu mehreren in Reihe geschalteten Solarzellen zu ermöglichen. Die Wirtschaftlichkeit des Solarmoduls wird auf diese Weise regelmäßig beeinträchtigt, da die für die Solarzellen zur Verfügung stehende Fläche durch diese Leiter, die notwendig vorgesehen sein müssen, reduziert wird. Zudem werden die Fertigungskosten des Solarmoduls hierdurch erhöht.

Grundsätzlich ist es ein Ziel für wirtschaftliche effiziente Solarmodule, dass eine solche Bypass-Diode nur wenige Solarzellen überbrückt, um eine individuelle Überbrückung abgeschatteter Solarzellen zu erreichen und hierdurch nicht solche Zellen in einer gemeinsamen Überbrückung mehrerer Solarzellen zu überbrücken, die nur durch die Abschattung benachbarter Zellen nicht mehr ihre elektrische Energie aus der Reihenschaltung effizient heraus transportieren können, grundsätzlich aber noch zur Produktion elektrischer Energie ausreichend bestrahlt wären. Diesem Ziel steht jedoch einerseits entgegen, dass hierdurch eine erhebliche Anzahl an Bypass-Dioden auf einem Solarmodul bereitgestellt sein müsste, was die wirtschaftliche Fertigung solcher Solarmodule beeinträchtigt. Zum anderen wird hierdurch ein erheblicher Leitungsaufwand erforderlich, der wiederum die wirtschaftliche Effizienz solcher Solarmodule reduziert.

Aus WO 2005/101511 A1 ist ein Photovoltaikmodul bekannt, bei dem Bypass-Dioden für eine Reihenschaltung von insgesamt 10 Solarzellen mittels elektrischer Verbindungen verbunden sind. Die Bypass-Dioden sind hierzu an voneinander elektrisch isolierte Sektionen angeschlossen. Diese Einheit ist dann zwischen einer Substratplatte und einer Rückplatte des Moduls eingefasst. Es hat sich gezeigt, dass in einer solchen Konfiguration eine ausreichend Wärmeabfuhr von den Bypass-Dioden nicht dauerhaft gewährleistet ist und eine Überhitzung der Dioden auftreten kann. Dies gefährdet die Betriebssicherheit und Zuverlässigkeit des Solarmoduls. Es ist ein erstes Ziel der Erfindung, ein Solarmodul bereitzustellen, welches eine gegenüber diesem Stand der Technik höhere Betriebssicherheit aufweist.

Diese Aufgabe wird erfindungsgemäß gelöst durch ein Photovoltaikmodul der eingangs genannten Art, bei dem die Diode mit einem ersten Leiter verbunden ist, der mit einer ersten Elektrode der parallel zur Diode geschalteten ersten Solarzelleneinheit elektrisch verbunden ist, die Diode mit einem zweiten Leiter verbunden ist, der mit einer zweiten, der ersten Elektrode entgegengesetzt gepolten Elektrode der parallel zur Diode geschalteten ersten Solarzelleneinheit elektrisch verbunden ist und der zweite Leiter benachbart zu dessen Verbindungsstelle mit der Diode ein Zugentlastungselement aufweist.

Mit dem erfindungsgemäßen Photovoltaikmodul wird eine fertigungstechnisch günstige und zugleich einen sehr effizienten Betrieb ermöglichende Konfiguration eines Photovoltaikmoduls bereitgestellt. Dabei liegt der Erfindung in fertigungstechnischer und konstruktiver Hinsicht die Erkenntnis zugrunde, dass bei dem Stand der Technik durch die Bereitstellung der Trägerplatten oder Streifen und deren durch Lötverbindung erzielte mechanische und elektrische Anbindung an die Bypass-Dioden zwar ein mechanisch zuverlässiger Verbund und Anschluss der Dioden erzielt werden kann, hierzu jedoch erheblicher fertigungstechnischer Aufwand betrieben werden muss. Dieser Aufwand wird erfindungsgemäß verringert und eine vorteilhafte und effizientere Fertigung ermöglicht, indem durch die spezifische Art der Anbindung der Bypassdiode auf einen Trägerplatte, Substratplatte, Platine oder einen Streifen funktionelle verzichtet werden kann und die Diode direkt an den ersten und zweiten Leiter angeschlossen, insbesondere angelötet werden kann.

Erfindungsgemäß wird in einem Photovoltaikmodul eine, im Regelfall jedoch mehrere Bypass-Dioden bereitgestellt, die jeweils eine Anzahl von Solarzellen, die in Reihe geschaltet sein können, parallel für den Fall der vollständigen oder teilweisen Abschattung überbrücken. Jede Bypass-Diode ist hierbei unmittelbar mittels eines ersten und zweiten Leiters in entsprechender Weise mit der Solarzelleneinheit elektrisch verbunden. Diese beiden elektrischen Leiter dienen zugleich auch dazu, um die Bypass-Diode mechanisch zu halten und gegen während der Fertigung, der Montage und des Betriebs auftretende Erschütterungen und mechanische Einwirkungen zu verankern und zu schützen. Das erfindungsgemäße Photovoltaikmodul kann aus diesem Grund auf eine mechanische Verankerung der Bypass-Diode auf einer Platte, wie einer Leiterplatte, einem Platinenstreifen oder dergleichen, verzichten und setzt die Bypass-Diode stattdessen direkt an die elektrischen Leiter an. Diese Konstellation wird ermöglicht, indem während des Betriebs auftretende mechanische, beispielsweise durch thermische Änderungen bewirkte Einflüsse, welche durch die Durchströmung der Diode oder andere Einflüsse auftreten, mittels eines Zugentlastungselements aufgefangen werden und daher eine Beschädigung der Diode oder der Anschlüsse in der Diode trotz einer fehlenden, die Diode mechanisch parallel überbrückenden, Zugkraft aufnehmenden Substruktur zuverlässig verhindert wird.

Ein weiterer Vorteil des erfindungsgemäßen Photovoltaikmoduls liegt in der besseren Wärmestabilität der Bypassdiode aufgrund verbesserter Wärmeabfuhr. Diesem Vorteil liegt die Erkenntnis zugrunde, dass zwar durch die Anordnung der Diode auf einer Platine oder Substratplatte oder dergleichen in leichter Weise Kühlkörper mit der Diode verbunden und die Flächen der Platine selbst als Kühlkörper genutzt werden können, dies aber nicht die Nachteile kompensiert, die aufgrund der eingefassten Lage der Bypassdiode zwischen Substratplatte bzw. Platine und Rückplatte des Solarmoduls und den dadurch verursachten Hitzestau hervorgerufen werden. Die erfindungsgemäße Anordnung mit einem Zugentlastungelement erlaubt eine direkte Verbindung der Bypassdiode mit dem ersten und zweiten Leiter, wodurch die Bypassdiode unmittelbar und ohne thermisch isolierende Platine in das Laminat des Photovoltaikmoduls eingebettet werden kann. Dies ermöglicht eine direkte Wärmeabfuhr aus der Bypassdiode in das Laminat in Richtung zur Vorder- und Rückseite des Photovoltaikmoduls, ohne dass hierbei eine thermisch isolierende Platine den Wärmeabfluss behindert.

Mit dem erfindungsgemäßen Photovoltaikmodul wird eine sowohl in fertigungstechnischer Hinsicht als auch in qualitativer Hinsicht besonders vorteilhafte Integration einer Bypass- oder Überbrückungsdiode in ein solches Modul bereitgestellt. Dies zeichnet sich dadurch aus, dass die Diode mit einem ersten und zweiten Leiter verbunden ist und in den zweiten Leiter ein Zugentlastungselement benachbart zur Verbindungsstelle mit der Diode vorhanden ist. Ein solches Zugentlastungselement dient dazu, um mechanische Spannungen auf die Diode, den Leiter und die Verbindungsstellen zwischen Diode und Leiter zu verhindern oder zumindest auf ein solches Maß reduzieren, dass hierdurch keine Gefahr der Beschädigung der Diode oder dieser Verbindungsstellen zwischen Dioden und Leiter besteht. Zu diesem Zweck ist ein Zugentlastungselement gemäß der Erfindung solcher Art ausgestaltet, dass es eine Dehnbarkeit in zumindest einer Längsrichtung unter Krafteinwirkung ermöglicht. Das Zugentlastungselement ist dabei mechanisch in Reihe mit der Diode angeordnet. Die Dehnbarkeit des Zugentlastungselementes ist dabei erfindungsgemäß solcher Art bemessen, dass sich das Zugentlastungselement unter Einfluss einer Zugkraft auf das Zugentlastungselement mehr in Zugkraftrichtung dehnt als dies die Diode oder der elektrische Leiter unter Einwirkung der gleichen Zugkraft tut und dadurch den Aufbau großer Zugkräfte verhindert. Insbesondere ist es bevorzugt, dass sich das Zugentlastungselement unter Einwirkung einer Kraft um zumindest den Faktor zehn mehr dehnt als die Diode bzw. als der elektrische Leiter unter dieser Kraft. Grundsätzlich ist zu verstehen, dass das Zugentlastungselement auch als Druckentlastungselement wirkt, d. h. auch bei Einwirkung von Druckkräften auf den elektrischen Leitern und oder die Diode eine größere Komprimierung erfährt als die Diode bzw. der elektrische Leiter in der Richtung dieser Druckkraft und daher auch dem Aufbau großer Druckkräfte entgegenwirkt.

Durch ein solches Zugentlastungselement wird es ermöglicht, dass die Diode, ohne dass sie auf eine separate Platine oder einen Träger oder dergleichen aufmontiert und über diese Platine/Träger mit den elektrischen Leitern kontaktiert wird, unmittelbar mit den elektrischen Leitern verbunden wird. Eine mechanisch parallel zur Diode angeordnete Platine bzw. ein Träger können grundsätzlich zwar als Zugaufnahmeelemente die Diode vor schädlichen Krafteinwirkungen aufgrund von Zug- oder Druckkräften auf die elektrischen Leiter schützen, allerdings weist dies nach Erkenntnis der Erfinder Nachteile in verschiedenen Bereichen auf. Zum einen wird die gesamte Bauhöhe einer solchen Konstruktion mit Diode und Platine bzw. Trägermaterial höher, was einem kompakten Aufbau eines Solarmoduls nicht zuträglich ist. Zum anderen wird durch eine solche Montage auf Platine/Träger nach wie vor die Problematik einer Beschädigung der elektrischen Kontakt zwischen den elektrischen Leitern und dieser Platine nicht vermieden, wodurch die Zuverlässigkeit solcher Art aufgebauter Photovoltaikmodule herabgesetzt wird.

Diese beiden Nachteile überwindet die Erfindung, indem einerseits ein flacher Aufbau der Diode ohne die Notwendigkeit von Platine/Träger eröffnet wird, zugleich aber die Gefahr einer mechanischen Beschädigung zuverlässig und sowohl für Diode als auch Kontaktierungsstellen und elektrischer Leiter verringert wird.

Insbesondere ermöglicht es die Erfindung, dass die Diode, angrenzende Bereiche der Leiter oder die gesamten Leiter sowie das Zugentlastungselement einlaminiert bzw. in einer Eingussmasse vergossen werden, was weiterhin die Zuverlässigkeit des erfindungsgemäßen Photovoltaikmoduls erhöht und darüber hinaus eine verbesserte Fertigungstechnik hinsichtlich Effizienz und Gefahr der Beschädigung während des Montagevorgangs eröffnet.

Gemäß einer ersten bevorzugten Ausführungsform ist vorgesehen, dass die Diode mittels einer ersten, flächigen Lotverbindung mit dem ersten Leiter verbunden ist, die Diode mittels einer zweiten flächigen Lotverbindung mit dem zweiten Leiter verbunden ist, wobei die erste flächige Lotverbindung und die zweite flächige Lotverbindung einen unterschiedlichen Verbindungsquerschnitt aufweisen. Gemäß dieser bevorzugten Ausgestaltung ist die Anordnung eines Zugentlastungselements insbesondere dann für das Photovoltaikmodul von Vorteil, wenn sich die beiden Lotverbindungen an der Diode voneinander hinsichtlich ihres Verbindungsquerschnittes unterscheiden. Durch eine solche Ausgestaltung wird in der Regel eine belastbarere und eine weniger belastbare Lotverbindung realisiert und dadurch die Notwendigkeit einer Zugentlastung zur Qualitätssicherung gesetzt. Durch die unterschiedliche Ausgestaltung der Lotverbindungen kann zudem bei der Montage und Verlötung der Diode eine höhere Sicherheit gegen eine fehlerhafte Verpolung der Diode erreicht werden, indem durch diese Unterschiedlichkeit eine bestimmte Montageausrichtung vorgegeben wird.

Noch weiter ist es bevorzugt, dass der unterschiedliche Verbindungsquerschnitt bereitgestellt ist, indem die erste flächige Lotverbindung einen größeren Verbindungsquerschnitt als die zweite flächige Lotverbindung aufweist. Gemäß dieser Ausführungsform unterscheiden sich die Verbindungsquerschnitte nicht notwendigerweise hinsichtlich ihrer Kontur, sondern weisen unterschiedlich große Verbindungsquerschnitte auf. Unter einem Verbindungsquerschnitt ist hierbei diejenige Fläche zu verstehen, die sowohl auf Diodenseite als auch auf Leiterseite übereinstimmend mit Lot benetzt ist und folglich zur Kraftübertragung zwischen Diode und Leiter beiträgt. Dabei ist zu verstehen, dass ein solcher Verbindungsquerschnitt auch aus mehreren voneinander beabstandeten Verbindungsquerschnittsabschnitten bestehen kann und sich dessen Größe in diesem Fall aus einer Aufsummierung dieser Verbindungsquerschnittsabschnitte ergibt.

Diese Ausführungsform zeichnet sich weiterhin durch einen weiteren Vorteil auf, der darin liegt, dass das Zugentlastungselement benachbart zu derjenigen (zweiten) flächigen Lotverbindung angeordnet ist, welche den kleineren Verbindungsquerschnitt der beiden Lotverbindungen an der Diode aufweist. Durch diese Konfiguration wird in Abkehr von anderen Konstellationen, die insbesondere eine Wärmeableitung aus der Diode adressieren, ein zusätzliches konstruktives Element, nämlich das Zugentlastungselement, im Bereich der schwächeren der beiden Lotverbindungen bereitgestellt. Auf diese Weise wird auch in Situationen, in denen sowohl das Zugentlastungselement als auch die Diode und daran angrenzende Leiterabschnitte zwischen zwei Folien einlaminiert sind oder in eine Vergussmasse eingebettet sind, einen zuverlässige Entlastung der schwächeren der beiden Lotstellen erreicht und hierdurch die Gefahr eines Bruches oder einer Teilablösung dieser Lotstelle signifikant verringert.

Gemäß einer weiteren bevorzugten Ausführungsform ist vorgesehen dass, die erste und/oder die zweite Solarzelleneinheit durch mehrere in Reihe geschaltete Solarzellen gebildet wird, insbesondere durch mehrere in Reihe geschaltete Solarzellen aus UMG-Silizium, und der erste und zweite Leiter einen Abschnitt eines elektrischen Querverbinders bilden, der mehrere Solarzelleneinheiten miteinander elektrisch verbindet. Diese Ausgestaltung des erfindungsgemäßen Photovoltaikmoduls definiert eine spezifische verschaltungstechnische Struktur des Photovoltaikmoduls, bei der die Dioden in dem Querverbinder zwischen mehreren Solarzelleneinheiten angeordnet sind. Diese Solarzelleneinheiten können dabei in Reihe oder parallel geschaltet sein und über diesen Querverbinder entsprechend miteinander verbunden sein. Die so bevorzugt bereitgestellte Konfiguration ermöglicht es, auf einer Modulgröße, die mehrere in einer Linie angeordnete Solarzellen und mehrere Spalten solcher linienförmig angeordneter Solarzellen aufweist, eine besonders platzsparende und günstige Anordnung der Dioden und der diese anschließenden elektrischen Leiter vorzunehmen, um hierdurch den Platzbedarf, der für diese Funktionselemente erforderlich ist, zu minimieren und folglich die Leistung pro Fläche des Photovoltaikmoduls zu maximieren.

Dabei ist es besonders bevorzugt, wenn die Solarzellen aus UMG-Silizium bestehen. UMG-Silizium (upgraded metallurgical grade silicon) sind kostengünstige Solarzellen, die sich im Vergleich zu Zellen aus multikristallinem oder monokristallinem Silizium durch eine geringere Rückwärts-Durchbruchsspannung auszeichnen. Aus diesem Grund können bei Verwendung von Solarzellen aus UMG-Silizium nur eine geringere Zahl von Zellen in Reihe geschaltet werden, wodurch sich die Anzahl der Bypass-Dioden, die für ein Solarmodul eingesetzt werden müssen, erhöht. Durch die so getroffene Anordnung wird folglich eine wirtschaftliche Möglichkeit der Zellverschaltung auch für solche Photovoltaikmodule mit UMG-Siliziumzellen ermöglicht, indem die Dioden an geeigneter Stelle ins Laminat integriert werden können. Insbesondere ermöglicht diese Konfiguration, Anordnung und Integration der Dioden eine Herstellung von auch großen Photovoltaikmodulen mit einer hohen Anzahl an UMG-Siliziumzellen.

Noch weiter ist es bevorzugt, dass das Zugentlastungselement durch einen mehrfach entgegengesetzt abgewinkelten Abschnitt des zweiten Leiters oder einen Abschnitt, der bereichsweise Ausnehmungen aufweist, gebildet wird. Diese Ausgestaltung, die beispielsweise also eine Zieharmonika-ähnliche Ausführung des Zugentlastungselementes oder eine durch wechselweise seitliche Austanzungen schlangenförmige Ausführung des Zugentlastungselementes bereitstellt, erlaubt eine wirtschaftliche Fertigung eines solchen Zugentlastungselementes ohne dass hierfür in Kauf genommen werden müsste, dass sich der elektrische Widerstand im Bereich des Zugentlastungselementes maßgeblich oder überhaupt erhöht.

Gemäß einer weiteren bevorzugten Ausführungsform ist vorgesehen, dass die Diode, zumindest ein benachbart zur Diode liegender Abschnitt des ersten Leiters und zumindest ein benachbart zur Diode liegender Abschnitt des zweiten Leiters, das Zugentlastungselement, und/oder der erste und/oder der zweite Leiter entlang seines Verlaufs von der Diode zur Solarzelleneinheit in eine Vergussmasse oder zwischen zwei Laminatfolien eingebettet sind, insbesondere allseitig von der Vergussmasse bzw. den Laminatfolien umschlossen sind.

Mit dieser bevorzugten Ausführungsform wird eine Integration derjenigen funktionalen Elemente oder Teilen davon in dem Photovoltaikmodul realisiert, die durch Einlaminierung bzw. Umgießen mit einer Vergussmasse einen insoweit belastbaren, gegen Erschütterungen gesicherten und zudem gegen Feuchtigkeit unempfindlichen Verbund herstellt. Dabei ist, wie zuvor erläutert, diese Anordnung mit einlaminierter bzw. vergossener Diode und ggf. darüber hinaus auch einlaminierter bzw. vergossener Abschnitte der elektrischen Leiter und des Zugentlastungselementes insbesondere vorteilhaft, da durch die Konfiguration des Zugentlastungsselementes und dessen Anordnung im Bereich benachbart zu einer elektrischen Verbindungsstelle zwischen Leiter und Diode auch in einem solchen einlaminierten bzw. vergossenen Verbund eine Beschädigung der Lotstelle infolge von Zug- oder Druckspannungen, die in deren Bereich durch mechanische Erschütterungen, thermische Belastungen oder dergleichen auftreten, vermieden werden kann.

Das erfindungsgemäße Photovoltaikmodul oder andere Photovoltaikmodule können bevorzugt nach einem Verfahren zur Herstellung eines Photovoltaikmoduls hergestellt werden, welches die Schritte umfasst:
Bereitstellen einer ersten und einer zweiten Solarzelleneinheit und gegebenenfalls weiterer Solarzelleneinheiten,
Verbinden der ersten und zweiten Solarzelleneinheit miteinander in einer elektrischen Reihenschaltung zur Erzeugung einer addierten Zellenspannung, Verbinden einer Überbrückungsdiode elektrisch parallel mit der ersten Solarzelleneinheit zur Überbrückung der Solarzelleneinheit im Falle einer vollständigen oder teilweisen Abschattung der ersten Solarzelleneinheit,
Verbinden der Diode mit einem ersten Leiter, und
Verbinden des ersten Leiters mit einer ersten Elektrode der parallel zur Diode geschalteten ersten Solarzelleneinheit elektrisch,
Verbinden der Diode mit einem zweiten Leiter, und
Verbinden des zweiten Leiters mit einer zweiten, der ersten Elektrode entgegengesetzt gepolten Elektrode der parallel zur Diode geschalteten ersten Solarzelleneinheit und
Implementieren eines Zugentlastungselement im zweiten Leiter benachbart zu dessen Verbindungsstelle mit der Diode.

Mit diesem Verfahren wird es ermöglicht, ein Photovoltaikmodul in einer effizienten Weise herzustellen, welches in qualitativer Hinsicht eine vorteilhafte Integration einer bzw. mehrerer Bypass-Dioden und deren elektrischer Verbindung ermöglicht.

Das Verfahren kann bevorzugt so ausgeführt werden, dass die Diode mittels einer ersten, flächigen Lotverbindung mit dem ersten Leiter verbunden wird, die Diode mittels einer zweiten flächigen Lotverbindung mit dem zweiten Leiter verbunden wird, wobei die erste flächige Lotverbindung und die zweite flächige Lotverbindung einen unterschiedlichen Verbindungsquerschnitt aufweisen.

Schließlich ist es noch weiter bevorzugt, dass die erste flächige Lotverbindung einen größeren Verbindungsquerschnitt als die zweite flächige Lotverbindung aufweist.

Gemäß einer weiteren Verfahrensfortbildung ist vorgesehen, dass die erste und/oder die zweite Solarzelleneinheit durch mehrere in Reihe geschaltete Solarzellen gebildet wird, insbesondere durch mehrere in Reihe geschaltete Solarzellen aus UMG-Silizium, und mehrere Solarzelleneinheiten mittels eines elektrischen Querverbinders miteinander elektrisch verbunden werden und der erste und zweite Leiter jeweils einen Abschnitt dieses Querverbinders darstellen.

Das Verfahren kann weiter fortgebildet werden, indem der zweite Leiter in einem benachbart zur Diode liegenden Abschnitt mehrfach entgegengesetzt abgewinkelt wird und dieser mehrfach entgegengesetzt abgewinkelte Abschnitt das Zugentlastungselement des zweiten Leiters bildet.

Weiter bevorzugt ist vorgesehen, dass die Diode, zumindest ein benachbart zur Diode liegender Abschnitt des ersten Leiters und zumindest ein benachbart zur Diode liegender Abschnitt des zweiten Leiters, das Zugentlastungselement, und/oder der erste und/oder der zweite Leiter entlang seines Verlaufs von der Diode zur Solarzelleneinheit in eine Vergussmasse oder zwischen zwei Laminatfolien eingebettet werden, insbesondere allseitig von der Vergussmasse bzw. den Laminatfolien umschlossen werden.

Bezüglich des Herstellungsverfahren und der Fortbildungen des Verfahrens wird Bezug genommen auf die zuvor im Hinblick auf die hierzu korrespondierenden Eigenschaften des Photovoltaikmoduls und deren Merkmale erläuterten Vorteile und technischen Besonderheiten.

Bevorzugte Ausführungsformen der Erfindung werden anhand der beiliegenden Figuren erläutert. Es zeigen:
Fig. 1 eine schematische Seitenansicht einer einlaminierten Bypass-Diodenanordnung an einem ersten und einem zweiten elektrischen Leiter,
Figur 2 eine schematische schaltungstechnische Darstellung einer Platzierung mehrerer Bypass-Dioden gemäß Figur 1 und deren elektrischer Anschlussweise in einem Photovoltaikmodul mit mehreren Solarzellen und

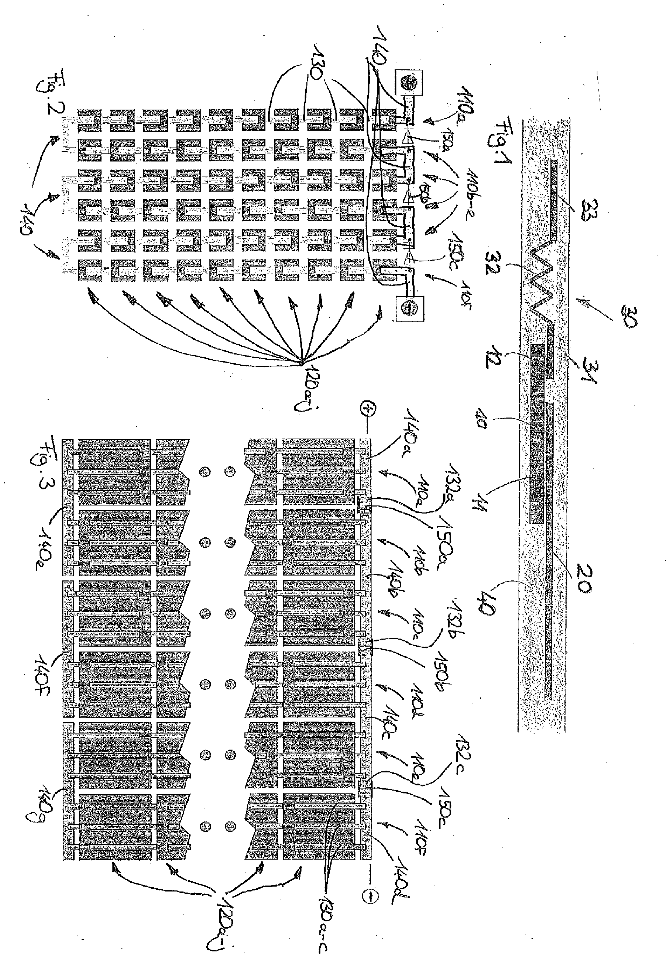

Figur 3 zeigt eine schematische konstruktive Darstellung einer Platzierung mehrerer Bypass-Dioden gemäß Figur 1 und deren elektrischer Anschlussweise in einem Photovoltaikmodul mit mehreren Solarzellen gemäß Figur 2.Fig. 1 zeigt eine Bypass-Diode 10, die eine erste elektrische Kontaktstelle 11 und eine zweite Kontaktstelle 12 auf einer Oberseite der Bypass-Diode aufweist. Die Querschnittsfläche der ersten elektrischen Kontaktfläche 11 weist eine größere Fläche auf als diejenige der zweiten elektrischen Kontaktfläche 12.Wie aus Figur 1 ersichtlich, ist an der ersten elektrischen Kontaktfläche ein erster elektrischer Leiter 20 angeordnet und flächig verlötet der als geradliniges Flachband aus einem elektrisch leitenden Material ausgeführt ist.

An der zweiten elektrischen Kontaktfläche ist ein zweiter elektrischer Leiter 30 angelötet. Der zweite elektrische Leiter besteht aus insgesamt drei Leiterabschnitten. Ein erster, geradliniger elektrischer Leiterabschnitt 31 ist als elektrisch leitendes Flachband in gleicher Weise wie der erste elektrische Leiter 20 ausgeführt und mit der zweiten elektrischen Kontaktfläche 12 an einem Ende des Leiterabschitts 31 verlötet.

Ein mit diesem ersten Leiterabschnitt 31 des zweiten elektrischen Leiters verbundener Zugentlastungsabschnitt 32 ist als wechselweise hin- und hergefalteter Bandabschnitt nach Art einer Zieharmonika ausgeführt.

Ein mit diesem zweiten Leiterabschnitt 32 verbundener dritter Leiterabsschnitt 33 ist wiederum in gleicher Weise wie der erste Leiterabschnitt als geradlinig verlaufendes, elektrisch leitenden Flachband ausgeführt.

Es ist zu verstehen, dass der erste, zweite und dritte Leiterabschnitt 31-33 aus einem einzigen Ausgangsmaterial in Form eines elektrisch leitenden Flachbandes ausgeführt sein kann und hergestellt werden kann, indem aus diesem Ausgangsmaterial durch mehrmaliges Hin- und Herfalten an beabstandeten Faltungspunkten der zweite Leiterabschnitt 32 hergestellt wird.

Die gesamte Anordnung, bestehend aus der Diode 10 und den beiden daran verlöteten elektrischen Leitern 20 und 30, ist in eine Vergussmasse 40 eingebettet und vollständig von dieser Vergussmasse umhüllt. Zusätzlich ist dieser so vergossene Block zwischen eine obere und eine untere Folie einlaminiert, die Bestandteil einer Abdeckung des gesamten Photovoltaikmoduls auf Vorder- und Rückseite ist.

Figur 2 zeigt eine schematische Ansicht der Verschaltung einer Vielzahl von Solarzellen in einem Photovoltaikmodul gemäß der Erfindung.

Die Solarzellen sind in insgesamt sechs Spalten 110 a-f und zehn Reihen 120 a-j angeordnet. Die Solarzellen jeweils einer Spalte sind in Reihe geschaltet und hierzu mittels entsprechender Längsverbinder 130 miteinander verbunden. Am oberen und unteren Ende sind diese Längsverbinder zweier benachbarter Spalten jeweils durch entsprechende Querverbinder 140 miteinander verbunden, wobei die Querverbinder alternierend am oberen bzw. unteren Ende der Spalten angeordnet sind. Hierdurch ergibt sich auch eine Reihenschaltung der Spalten 110 a-f, sodass in dem Photovoltaikmodul insgesamt alle 60 darin angeordneten Solarzellen in Reihe geschaltet sind. Am oberen, am weitesten links liegenden Querverbinder ist der Plusanschluss des Photovoltaikmoduls und am oberen, am weitesten rechts liegenden Querverbinder ist der Minusanschluss des Photovoltaikmoduls.

Erfindungsgemäß sind zwischen jeweils zwei benachbarte obere Querverbinder Bypass-Dioden geschaltet, was bei insgesamt sechs Spalten in diesem Fall drei Bypass-Dioden 150a, b, c ergibt. Die Bypass-Dioden sind dabei so angeordnet, dass sie insgesamt 20 Solarzellen aus den zwei benachbarten Spalten überbrücken und hierbei ihre Kathode mit der zum Plus-Anschluss liegenden Querverbinder dieser Solarzellen elektrisch verbunden ist und die Anode mit dem zum Minus-Anschluss weisenden oberen Querverbinder dieser 20 Solarzellen elektrisch verbunden ist. Die Bypass-Diode ist daher in der Lage, im Falle, dass durch Abschattung oder mehrerer dieser 20 von ihr parallel gebrückten Solarzellen eine Sperrwirkung in dieser Reihenschaltung der 20 Solarzellen auftritt, den durch die übrigen 40 Solarzellen in dem Photovoltaikmodul erzeugten Strom durchzulassen und hierdurch die Effizienz des Photovoltaikmoduls teilweise aufrechtzuerhalten.

Figur 3 zeigt die konkrete konstruktive Ausgestaltung eines erfindungsgemäßen Photovoltaikmoduls. Zu erkennen ist, dass sich insgesamt vier Querverbinder 140 a-d als streifenförmiger Leiter mit einer Breite von nicht weniger als 10 mm am oberen Ende des Photovoltaikmoduls erstreckt und am unteren Ende drei Querverbinder 140 e-g in gleicher Weise durch eine streifenförmigen Leiter angeordnet sind.

Die benachbart zu den Querverbindern liegenden Solarzellen sind mit jeweils drei Längsverbindern 130 a-c mit dem Querverbinder elektrisch verbunden und die Solarzellen untereinander in einer Spalte ebenfalls durch drei solcher Längsverbinder verbunden, wobei sich die Längsverbinder der oberen, zu den oberen Querverbindern benachbarten Reihe von Solarzellen alternierend so erstrecken, dass wechselweise immer drei Längsverbinder mit der Anodenseite einer Solarzelle verbunden sind, dann drei Längsverbinder mit der Kathodenseite einer Solarzelle verbunden sind, hierauffolgend wiederum drei Längsverbinder mit der Anodenseite usw. Am unteren Ende ist dies ebenso, allerdings invers, wechselweise ausgeführt, wobei ein Querverbinder einerseits mittels dreier Längsverbinder mit der Kathodenseite einer Solarzelle der unteren Spalte und dann mittels dreier anderer Längsverbinder mit der Anodenseite der hierzu in der gleichen Reihe in benachbarter Spalte liegenden Solarzelle verbunden ist und diese beiden Solarzellen folglich in Reihe miteinander verbindet.

Die Bypass-Dioden 150a, b, c sind nun direkt mit den oberen Querverbindern 140 a-d verbunden. Diese Verbindung ist ausgeführt, indem die Dioden unmittelbar mit ihrer Kathodenseite mit einem Querverbinder durch Löttechnik verbunden sind und weiterhin unmittelbar mit ihrer Anodenseite mit einem hierzu benachbart liegenden Querverbinder unmittelbar verbunden sind. Dabei ist weiterhin ein Zugentlastungselement 132 a-c benachbart zu jeder Diode zwischen den Querverbinder und die Diode mechanisch und elektrisch in Reihe geschaltet und sorgt somit für eine Durchleitung des Stroms und mechanische Entlastung gegen Zug-und Druckkräfte der Diode, die aufgrund dieses Zugentlastungselementes in der beschriebenen Weise unmittelbar mit den Querverbindern verlötet werden kann.

Die gesamte Anordnung aus Querverbindern, Dioden, Solarzellen und Längsverbindern ist dann vollständig einlaminiert und hierdurch vor mechanischen Einwirkungen zuverlässig geschützt. Durch diese direkte Lage zwischen front- und rückseitigem Laminat können die Bypass-Dioden die durch den Stromfluss durch sie hindurch erzeugte Wärme zuverlässig und dauerhaft abführen.

## Patentansprüche

1. Photovoltaikmodul, umfassend:
Zumindest eine erste und eine zweite Solarzelleneinheit, die miteinander elektrisch in einer Reihenschaltung verbunden sind zur Erzeugung einer addierten Zellenspannung,
eine Überbrückungsdiode, die elektrisch parallel mit der ersten Solarzelleneinheit verbunden ist zur Überbrückung der Solarzelleneinheit im Falle einer vollständigen oder teilweisen Abschattung der ersten Solarzelleneinheit,
**dadurch gekennzeichnet, dass**
- die Diode mit einem ersten Leiter verbunden ist, der mit einer ersten Elektrode der parallel zur Diode geschalteten ersten Solarzelleneinheit elektrisch verbunden ist,
- die Diode mit einem zweiten Leiter verbunden ist, der mit einer zweiten, der ersten Elektrode entgegengesetzt gepolten Elektrode der parallel zur Diode geschalteten ersten Solarzelleneinheit elektrisch verbunden ist,
- der zweite Leiter benachbart zu dessen Verbindungsstelle mit der Diode ein Zugentlastungselement aufweist.

2. Photovoltaikmodul nach Anspruch 1, **dadurch gekennzeichnet, dass**
- Die Diode mittels einer ersten, flächigen Lotverbindung mit dem ersten Leiter verbunden ist,
- Die Diode mittels einer zweiten flächigen Lotverbindung mit dem zweiten Leiter verbunden ist,
- Wobei die erste flächige Lotverbindung und die zweite flächige Lotverbindung einen unterschiedlichen Verbindungsquerschnitt aufweisen.

3. Photovoltaikmodul nach Anspruch 2,
**dadurch gekennzeichnet, dass** der unterschiedliche Verbindungsquerschnitt bereitgestellt ist, indem die erste flächige Lotverbindung einen größeren Verbindungsquerschnitt als die zweite flächige Lotverbindung aufweist.

4. Photovoltaikmodul nach einem der vorhergehenden Ansprüche,
**dadurch gekennzeichnet, dass** die erste und/oder die zweite Solarzelleneinheit durch mehrere in Reihe geschaltete Solarzellen gebildet wird, insbesondere durch mehrere in Reihe geschaltete Solarzellen aus UMG-Silizium, und der erste und zweite Leiter einen Abschnitt eines elektrischen Querverbinders bilden, der mehrere Solarzelleneinheiten miteinander elektrisch verbindet.

5. Photovoltaikmodul nach einem der vorhergehenden Ansprüche,
**dadurch gekennzeichnet, dass** das Zugentlastungselement durch
- einen mehrfach entgegengesetzt abgewinkelten Abschnitt des zweiten Leiters oder
- einen Abschnitt, der bereichsweise Ausnehmungen aufweist, gebildet wird.

6. Photovoltaikmodul nach einem der vorhergehenden Ansprüche,
**dadurch gekennzeichnet, dass**
- die Diode, zumindest ein benachbart zur Diode liegender Abschnitt des ersten Leiters und zumindest ein benachbart zur Diode liegender Abschnitt des zweiten Leiters,
- das Zugentlastungselement, und/oder
- der erste und/oder der zweite Leiter entlang seines Verlaufs von der Diode zur Solarzelleneinheit
in eine Vergussmasse oder zwischen zwei Laminatfolien eingebettet sind, insbesondere allseitig von der Vergussmasse bzw. den Laminatfolien umschlossen sind.

7. Verfahren zur Herstellung eines Photovoltaikmoduls, mit den Schritten:
Bereitstellen einer ersten und einer zweiten Solarzelleneinheit und gegebenfalls weiterer Solarzelleneinheiten
Verbinden der ersten und zweiten Solarzelleneinheit miteinander in einer elektrischen Reihenschaltung zur Erzeugung einer addierten Zellenspannung,
Verbinden einer Überbrückungsdiode elektrisch parallel mit der ersten Solarzelleneinheit zur Überbrückung der Solarzelleneinheit im Falle einer vollständigen oder teilweisen Abschattung der ersten Solarzelleneinheit, **gekennzeichnet durch** die Schritte:
- Verbinden der Diode mit einem ersten Leiter, und
- Verbinden des ersten Leiters mit einer ersten Elektrode der parallel zur Diode geschalteten ersten Solarzelleneinheit elektrisch,
- Verbinden der Diode mit einem zweiten Leiter, und
- Verbinden des zweiten Leiters mit einer zweiten, der ersten Elektrode entgegengesetzt gepolten Elektrode der parallel zur Diode geschalteten ersten Solarzelleneinheit,
- Implementieren eines Zugentlastungselement im zweiten Leiter benachbart zu dessen Verbindungsstelle mit der Diode.

8. Verfahren nach Anspruch 7,
**dadurch gekennzeichnet, dass**
- Die Diode mittels einer ersten, flächigen Lotverbindung mit dem ersten Leiter verbunden wird,
- Die Diode mittels einer zweiten flächigen Lotverbindung mit dem zweiten Leiter verbunden wird,
- Wobei die erste flächige Lotverbindung und die zweite flächige Lotverbindung einen unterschiedlichen Verbindungsquerschnitt aufweisen.

9. Verfahren nach Anspruch 8,
**dadurch gekennzeichnet, dass** die erste flächige Lotverbindung einen größeren Verbindungsquerschnitt als die zweite flächige Lotverbindung aufweist.

10. Verfahren nach einem der vorhergehenden Ansprüche 8 oder 9,
**dadurch gekennzeichnet, dass** die erste und/oder die zweite Solarzelleneinheit durch mehrere in Reihe geschaltete Solarzellen gebildet wird, insbesondere durch mehrere in Reihe geschaltete Solarzellen aus UMG-Silizium, und mehrere Solarzelleneinheiten mittels eines elektrischen Querverbinders miteinander elektrisch verbunden werden und der erste und zweite Leiter jeweils einen Abschnitt dieses Querverbinders darstellen..

11. Verfahren nach einem der vorhergehenden Ansprüche 8-10,
**dadurch gekennzeichnet, dass** der zweite Leiter in einem benachbart zur Diode liegenden Abschnitt mehrfach entgegengesetzt abgewinkelt wird und dieser mehrfach entgegengesetzt abgewinkelte Abschnitt das Zugentlastungselement des zweiten Leiters bildet.

12. Verfahren nach einem der vorhergehenden Ansprüche 8-11,
**dadurch gekennzeichnet, dass**
- die Diode, zumindest ein benachbart zur Diode liegender Abschnitt des ersten Leiters und zumindest ein benachbart zur Diode liegender Abschnitt des zweiten Leiters,
- das Zugentlastungselement, und/oder
- der erste und/oder der zweite Leiter entlang seines Verlaufs von der
Diode zur Solarzelleneinheit
in eine Vergussmasse oder zwischen zwei Laminatfolien eingebettet werden, ins-besondere allseitig von der Vergussmasse bzw. den Laminatfolien umschlossen werden.
